# EUROPEAN PATENT SPECIFICATION

(11) **EP 3 869 269 B1**
(45) Date of publication and mention of the grant of the patent: **07.05.2025**
(21) Application number: 21158234.1
(22) Date of filing: 19.02.2021
(51) Int. Cl.: G03F 7/12, G03F 7/20, G03F 7/30, G03F 7/40

(54) **METHOD AND DEVICE FOR FINISHING FLEXOGRAPHIC DIGITAL PRINTING PLATES**
VERFAHREN UND VORRICHTUNG ZUR FEINBEARBEITUNG VON DIGITALEN FLEXOGRAFISCHEN DRUCKPLATTEN
PROCÉDÉ ET DISPOSITIF DE FINITION DE PLAQUES D'IMPRESSION NUMÉRIQUES FLEXOGRAPHIQUES

(30) Priority: 21.02.2020 IT 202000003686
(43) Date of publication of application: 25.08.2021
(73) Proprietor: SASU VIANORD ENGINEERING, 06510 Carros (FR)
(72) Inventor: DE CARIA, Riccardo, 20080 Basiglio (IT)
(74) Representative: De Bortoli, Tiziano

(56) References cited:
- US-A1- 2004 219 458
- US-A1- 2016 229 173
- US-A1- 2018 217 502
- US-A1- 2019 022 994
- "User's manual 'concept 302 ECDLF", 1 September 2014, GLUNZ & JENSEN DEGRAAF, article ANONYMOUS: "Parts 1 - 4", pages: 0.3 - 4.6, XP055561016
- ANONYMOUS: "Cyrel 1000 ECLF", DATA-SHEET - DUPONT, 1 May 2013 (2013-05-01), pages 1 - 2, XP055561011, Retrieved from the Internet <URL:https://www.dupont.com/content/dam/dupont/amer/us/en/cyrel/Public/documents/EDS-NA0002-EN_Cyrel_1000_ECLF-i.pdf> [retrieved on 20190225]

## Description

The present invention relates to a method and to a device for finishing flexographic digital printing plates. The present invention also concerns an apparatus for manufacturing flexographic digital printing plates comprising this device.

Flexography, also known with the term flexo, is a direct rotary printing method that uses relief matrices made with photopolymer materials. These matrices, called printing plates are of flexible and soft type. They are wrapped around a print cylinder, or press cylinder, and inked. Printing is obtained through direct deposition of the ink on the medium to be printed by means of a slight pressure exerted by said cylinder on said print medium.

Flexography is a high speed printing process that can be used to print on various kinds of media, made both of absorbent and non-absorbent material. Initially, flexographic printing was used to produce paper and plastic bags, milk cartons, disposable cups and the like. However, due to the improved printing features, today this technology is also used for printing newspapers, envelopes, labels, and also for printing on plastic, films, acetate sheets, wrapping paper and on many other materials used in packaging.

In order to obtain a high print quality, it is essential to take great care over the preparation of the flexographic plate. This preparation comprises various steps, including: a step of exposing the plate to ultraviolet (UV) light, aimed at photopolymerizating it, a subsequent washing step, aimed at removing the non polymerized portions, followed by a drying step and then by a finishing step.

To obtain the relief characters, the plate is polymerized only at specific portions of a light-proof mask, which have been previously made permeable to light. In particular, in the case of analogical printing plates, a film that reproduces a negative of the image to be printed is applied to the plate. In this case, the film acts as a mask. Differently, in the case of digital printing plates, the photopolymer is initially covered by a surface layer of opaque material, i.e., a light-proof material, such as graphite. In this case, this surface layer acts as a mask and is thus etched so as to create the negative of the image to be printed. The etching step is usually carried out using a digital laser controlled by a computer.

Exposure of the plate to light causes polymerization of only those parts of the plate located at portions of the mask that are permeable to light, thereby forming the image to be printed in relief on the photopolymer.

Currently, this photo-exposure step is carried out using conventional UV lamps or using LED lamps, as for example described in the patent documents WO 2013/156942 A1, US 2016/0229173 A1 and EP 3121653 B1. The exposure time to the light varies as a function of the intensity of radiated power in the unit of time and, secondarily, as a function of the thickness of the plate.

Subsequently, the flexographic plate undergoes a washing step aimed at removing the portions of material that have not been exposed to light and that therefore are not polymerized. This step can be carried out using a solvent that, by penetrating the polymer, dissolves the unpolymerized portions, or using water that causes detachment of the unpolymerized portions, which are subsequently removed by means of special brushes. Alternatively to washing with solvent and washing with water, thermal washing can be used.

Subsequently, the plate is subjected to a drying step, normally carried out in a drying oven, in order to remove the water or solvent used in the washing step.

A finishing station, wherein the flexographic plate undergoes a finishing treatment, is generally present downstream of the drying oven.

US 2018/0217502 discloses a device for producing flexographic printing plates starting from digitally imagable flexographic printing elements, with which at least the method steps of reverse exposure, main exposure, development using washout media, drying, and aftertreatment can be carried out in automated form, the device comprising at least two different transport devices with which the flexographic printing elements or plates, respectively, are transported through the device. In this known device, after the flexographic printing plate has been dried, it is pushed into a aftertreatment unit, i.e. a finishing unit, where the finishing is actuated in a static way, and then it is displaced into a storage unit.

The finishing treatment, in general, consists in exposing the flexographic plate to a plurality of neon lamps that emit UV-A and/or UV-C radiation. The first are used to polymerize any soft portions of the photopolymer, i.e., portions not polymerized and not washed away in the washing step, while the second are used to eliminate any surface stickiness of the plates after the washing step. Moreover, the UV-C radiations perform a germicidal action.

This is an extremely important step as the condition of the surface of the plate has a decisive influence on the transfer of ink during printing. In fact, the stickier the plate is, the more ink it will retain, leading to poor results in terms of print quality.

Moreover, the amount of ink required for printing depends on the surface quality of the plate, and hence on the finishing step. In other words, the dirtier, i.e. stickier, the plate is, the more ink will be required during the printing process, with obvious drawbacks from a cost point of view.

The most delicate parameter of the finishing step of methods known so far consists in its duration. In fact, if the exposure time of the plate to the UV-A and UV-C lamps were too short, the plate would be sticky and hence have the aforesaid drawbacks. On the contrary, an exposure time that is too long would cause cracking of the plate, i.e., it would stiffen and break. Even if it would not actually break, a rigid plate would be unable to perform the function for which it is intended.

The intensity of the light radiation emitted by a neon lamp can vary from 2 mW/cm² up to 17 mW/cm². Due to their intrinsic structure, in neon lamps this intensity varies constantly. In fact, as it uses a gas, a neon lamp heats up to a different degree each time, so that the intensity of the radiation cannot be controlled. As it is easy to understand, this causes numerous problems during the finishing step.

Moreover, neon lamps are subject to constant and unpredictable deterioration, making it impossible to schedule their replacement.

Consequently, the operator is currently required to evaluate the most suitable exposure time each time. This leads to several problems as, in order to obtain a suitable finishing of the plate, it is necessary to train specialized personnel, responsible for this evaluation. Moreover, even if specialized personnel are suitably trained, possible human errors and consequently high production waste must be taken into account.

To overcome this problem, it has been proposed the use of a light integrator to associate with each neon lamp, which integrator comprises a light sensor and an additional light source that emits a variable light radiation based on the light detected by the sensor. This solution is very expensive and difficult to implement, in terms of space and alignment.

Therefore, the duration of photo-exposure is the bottleneck of currently known finishing processes.

Based on these considerations, there is clearly the need to provide a method and a finishing device that allow the aforesaid problems to be eliminated or limited.

Therefore, the object of the present invention is to provide a method and a device for finishing flexographic digital printing plates that overcomes the problems of known finishing methods and devices.

In particular, within this aim, a first object of the present invention is to provide a finishing method that allows a controllable exposure to UV-A and UV-C rays to be achieved.

A second object of the present invention is to provide a method of finishing flexographic plates that can be implemented simply and at competitive costs.

Yet another object of the subject matter of the present invention is to provide a device for finishing flexographic plates that attains flexographic plates with suitable flexibility and, simultaneously, clean surfaces, i.e., without stickiness.

A further object of the subject matter of the present invention is to provide a device for finishing flexographic plates that is simple and cheap.

One more object of the present invention is to provide an apparatus for manufacturing flexographic digital printing plates that is complete, compact and fully automated.

The first two objects are achieved by means of a method of finishing flexographic digital printing plates comprising the steps of:
a. providing a plurality of UV-A LEDs and a plurality of UV-C LEDs, the LEDs being placed so that their radiating surface faces the surface of the plate to be treated;
b. providing means for relative movement between the plate being processed, said plurality of UV-A LEDs and said plurality of UV-C LEDs;
c. radiating the surface of the plate to be treated by means of said plurality of UV-A LEDs and said plurality of UV-C LEDs;
d. moving the plate being processed or the plurality of UV-A LEDs and the plurality of UV-C LEDs along a feed direction, with a such a speed that the entire surface to be treated is radiated by the LEDs for a prefixed time.

This method, by providing the use of LEDs as light source for radiating the plate, allows a controllable finishing step to be obtained, as the light intensity of the LEDs is 13-14 mW/cm², i.e., substantially constant. Moreover, the LEDs have a predictable deterioration of around 6% every 10,000 hours of work, so that it is possible to schedule maintenance. All this makes it possible to obtain a finished plate with an optimal surface and consequently a high print quality.

Moreover, the use of UV radiation coming from LEDs, instead of from conventional lamps, allows considerable savings in terms of energy and hence in terms of costs.

Moreover, the relative movement between the plate being processed and the plurality of LEDs allows reducing the number of the LEDS used and therefore also the footprint of the device wherein the method is actuated.

Furthermore, such relative movement achieves speeding up the method in apparatus for manufacturing flexographic digital printing plates of horizontal development, as explained in the following, since the plate is finished while being transferred from one station (for example a washing unit or a drying unit) to the other (for example a storage unit).

Finally, a method of this kind is simple to implement.

Advantageously, the method of the invention further comprises the following step:
e. providing a CPU designed to adjust the moving speed of the plate or the moving speed of the UV-A LEDs and UV-C LEDs and/or the exposure intensity, according to the type of plate to be treated.

In this way, it is possible to automatically treat different plates in terms of materials and/or dimensions. For example, it is possible to affix a barcode to each plate to be treated and a barcode reader at the inlet of the device wherein the finishing method is carried out to automate the whole process.

Preferably, the finishing method according to the present invention further comprises the step f. of cooling the plate during or after the radiating step. This prevents the plate from overheating leading to negative effects in terms of flexibility and/or stability of the plate.

The further objects of the present invention are achieved with a device for finishing flexographic digital printing plates in accordance with claim 4. In particular, the aforesaid objects are achieved by means of a finishing device comprising:
- an exposure chamber hermetic to UV rays, wherein radiating of the plate to be treated is carried out;
- a plurality of UV-A LEDs and a plurality of UV-C LEDs placed inside the exposure chamber in such a way that their radiating surface faces the surface of the plate to be treated, said plurality of LEDs being suitable for radiating the plate being processed;
- means for relative movement between the plate being processed, said plurality of UV-A LEDs and said plurality of UV-C LEDs, suitable for moving the plate being processed or the plurality of UV-A LEDs and the plurality of UV-C LEDs along a feed direction.

Such finishing device, allowing the elimination of neon lamps, achieves clean flexographic plates, i.e. without surface stickiness, as the LEDs provided in the exposure chamber obtain a predictable and controllable finishing step.

Therefore, with such a device it is no longer necessary to train specialized personnel and the possibility of human errors occurring is avoided, with consequent advantages in terms of production waste. Moreover, a device of this kind can be produced simply and at low cost, besides allowing a reduction in operating costs.

Moreover, the presence of means for relative movement between the plate being processed and the plurality of LEDs allows reducing the number of the LEDS used in the finishing device and therefore also the footprint of the same device.

Advantageously, in the finishing device of the present invention, at least one between said plurality of UV-A LEDs and said plurality of UV-C LEDs is located along at least one line substantially orthogonal to the feed direction (of the plate or of the LEDs) so as to form at least one row of LEDs.

Preferably, each row of LEDs is enclosed in one or more LED lamps located along a row substantially orthogonal to the feed direction.

Preferably, the device of the invention further comprises a CPU designed to adjust the moving speed of the plate or the moving speed of the UV-A LEDs and UV-C LEDs and/or the exposure intensity, according to the type of plate to be treated. This feature allows the automation of a finishing process for plates of different type, as mentioned previously.

Means for adjusting the brightness of the LEDs and/or means for adjusting the distance between plate to be treated and LEDs may be provided in the device of the invention, in order to optimize the finishing process.

Means for cooling the plate are advantageously provided inside or outside the exposure chamber of the finishing device of the invention, so as to prevent it from overheating.

The last object set by the present invention, i.e., to provide an apparatus for manufacturing flexographic digital printing plates that is efficient, compact and fully automated, is achieved by means of an apparatus according to claims 9 and 10.

In particular, an apparatus for manufacturing flexographic digital printing plates comprising a finishing device as described in the present context is effective due to the high surface finish guaranteed by this finishing device.

An apparatus for manufacturing flexographic digital printing plates comprising a polymerization unit for polymerizing the plate, a washing unit for washing the polymerized plate, a finishing device as described above and handling means suitable for picking up the plate from the washing unit and for transferring it into the finishing device is complete, as all the steps for preparing the flexographic plate are carried out therein, compact, as the features of the present invention make it possible to carry out all the steps in a single apparatus, and fully automated, due to the handling means that make manual transfer of the plate from the washing unit to the finishing unit unnecessary.

Furthermore, the presence of means for relative movement between the plate being processed and the plurality of LEDs in the finishing device of such apparatus, achieves a faster finishing method in apparatus for manufacturing flexographic digital printing plates of horizontal development, as explained in the following, since the plate is finished while being transferred from one station (for example a washing unit or a drying unit) to the other (for example a storage unit).

In the present context, the term LED lamps refers to any light source comprising LEDs, such as LED tubes, LED bars, LED spotlights, LED panels.

In the present context, the wording *"the plate to be treated"* and the wording *"the plate being processed"* are both referred to the plate during the finishing method, which means that they refer respectively to *"the plate to be finished"* and to *"the plate being finished".* In general, in the present context, the terms *"treatment"* and *"process"* are equivalent and they both refer to the finishing process/treatment.

Further features and advantages of the present invention will be more apparent from the description of preferred, but non-exclusive, embodiments of a method and of a finishing device according to the invention, as well as of an apparatus for manufacturing a flexographic digital printing plate, illustrated by way of example in the accompanying drawings, wherein:
- Fig. 1 shows a schematic plan view of an exposure chamber of a finishing device according to a first embodiment of the present invention, wherein the method of the invention is carried out;
- Fig. 2 shows a cross-sectional schematic view of a second embodiment of a finishing device according to the present invention;
- Fig. 3 shows a partially sectional schematic view of an apparatus for manufacturing flexographic plates according to an embodiment of the present invention; and
- Fig. 4 shows a perspective schematic view of an apparatus for manufacturing flexographic plates in accordance with a further embodiment.

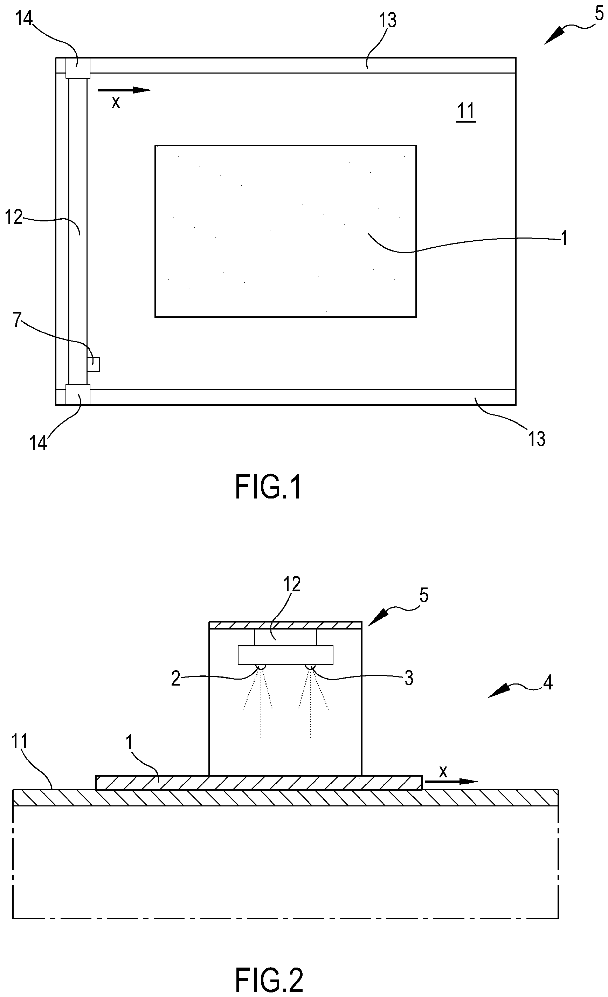

With reference to Figs. 1 to 4, a finishing device for flexographic printing plates is indicated as a whole with the reference numeral 4.

This finishing device 4 comprises an exposure chamber 5 hermetic to UV rays, wherein the plates 1 to be treated are radiated, with the aim of obtaining a clean and optimal surface for the printing process.

The finishing device 4 also comprises a base 11 on which the plates 1 being processed are placed during the finishing process. The plates 1 are placed directly or with the interposition of a medium on this base 11 so that the surface that does not require finishing treatment faces it.

A plurality of UV-A LEDs 2 and a plurality of UV-C LEDs 3 are located inside the exposure chamber 5. These pluralities are placed so that their radiating surfaces face the surface of the plate 1 to be treated and have the task of polymerizing any portions of plate 1 not polymerized during the previous photopolymerization process and not removed during the washing process. These LEDs also have the task of eliminating surface stickiness of the plate 1, as explained previously.

In the preferred embodiments, at least one between the plurality of UV-A LEDs 2 and the plurality of UV-C LEDs 3 is located along at least one straight line so as to form at least one row of LEDs. Even more preferably, both the UV-A LEDs 2 and the UV-C LEDs 3 are aligned to form respective rows, namely UV-A rows and UV-C rows. Each row is enclosed inside one or more LED lamps, aligned along said respective UV-A rows and UV-C rows.

The LED lamps are placed above the base 11, so as to radiate the plates 1 located thereon, and are supported by support means 12.

In the embodiments shown in the figures, the LED lamps (or the rows of LED lamps) are two, so that one UV-A row and one UV-C can be observed; however, it would be possible to provide several UV-A rows and several UV-C, preferably alternating one with the other.

In accordance with some embodiments, the finishing device 4 comprises one UV-C row interposed between two UV-A rows.

The UV-A rows and the UV-C rows are integral with one another.

According to the present invention, the finishing device 4 further comprises means for relative movement between the plate 1 being processed, said plurality of UV-A LEDs 2 and said plurality of UV-C LEDs 3. These movement means are suitable for moving the plate 1 being processed or the plurality of UV-A LEDs 2 and the plurality of UV-C LEDs 3 along a feed direction x, shown in Figs. 1 and 2.

This feed direction x is preferably rectilinear and substantially horizontal.

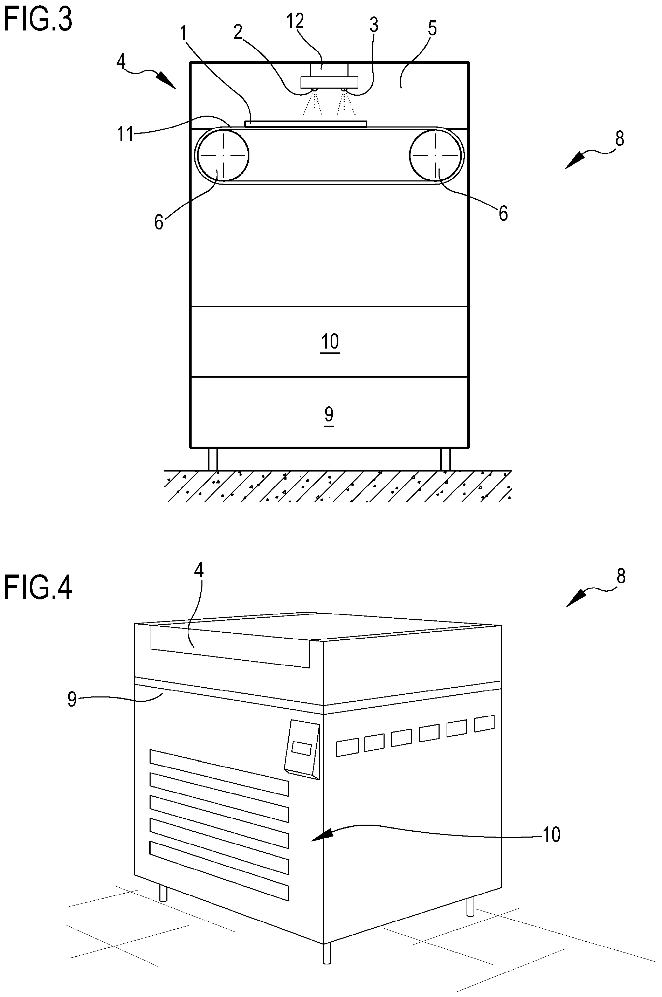

In the embodiments wherein the movement means are applied to the plate 1, such as in Fig. 2 or in Fig. 3, the plate 1 is translated from the inlet of the exposure chamber 5, to the outlet thereof. While, in the case in which the movement means are applied to the support means 12 of the rows of LEDs, such as in Fig. 1, the support means 12 are translated by the movement means from a start-of-stroke position to an end-of-stroke position.

Alternatively, it is possible for the plate 1 being processed and the support means 12, and consequently the LEDs, to translate simultaneously along the direction x in opposite directions.

As can be seen in the figures, the UV-A and UV-C rows are substantially orthogonal to the feed direction x.

The means for relative movement between the plate 1 being processed and the LED rows comprise at least one pair of drive rollers 6. In the embodiment shown in Fig. 3, these drive rollers 6 are placed below the plate 1 and are two: a first drive roller located at the inlet of the exposure chamber 5 and a second roller located at the outlet thereof. However, a different configuration could be provided, wherein one drive roller 6 is placed above the plate 1 and one below the plate 1. Alternatively, two pairs of drive rollers could be provided: a first pair placed at the inlet of the exposure chamber 5, and a second pair at the outlet thereof.

The drive rollers 6 drive the base 11 on which the plate 1 is located, and hence the plate 1 itself, in accordance with some embodiments of the present invention.

Alternatively, the means for relative movement comprise guides 13 parallel to the feed direction x and slides 14 suitable for sliding along these guides 13, as in the embodiment of Fig. 1. The guides 13 are preferably placed above or inside the exposure chamber 5, so as to avoid increasing the lateral footprint of the finishing device 4.

The slides 14 may be moved by means of a toothed belt rotated by a stepper motor or by equivalent means of known type.

It would be possible to provide movement means of a different type.

The finishing device 4 may be provided with a CPU designed to adjust the moving speed of the plate 1 or the moving speed of the UV-A LEDs 2 and UV-C LEDs 3 and/or the exposure intensity, according to the type of plate 1 to be treated. In other words, it is possible to provide the plates with a code, such as a barcode, identified by the finishing device 4 by means of the CPU. In this way, when the material and/or the dimensions of the plate 1 change, it is possible to automatically move the plate 1 or the LEDs at a higher or lower feed speed, according to the optimal exposure time for each plate 1.

In addition, or alternatively, it is possible to vary the exposure intensity, acting on the LEDs, for example through screen means or means for adjusting the brightness of another type, so that the plate 1 receives the intensity appropriate for the optimal finishing thereof. In this case, it is possible to use a brightness sensor 7 suitable for collaborating with the CPU.

A further addition or alternative is represented by means for adjusting the distance between plate 1 to be treated and LEDs, with the aim of adjusting the exposure intensity and the temperature of the plate 1.

The finishing device 4, in accordance with preferred embodiments, is also provided with means for cooling the plate 1, not shown in the figures. In the case in which the plate 1 is moved by the movement means, the cooling means are placed at the outlet of the exposure chamber 5. Alternatively, it is possible to provide cooling means inside the exposure chamber 5.

The cooling means are suitable for preventing overheating of the plate 1. It is in fact advisable for the plate 1 not to exceed the temperature of 60°C, for it to be suitable for the specific object of the invention.

Therefore, means for sensing the temperature, suitable for communicating with the CPU, are provided in the exposure chamber 5.

The finishing device 4 described above can be an independent device or can be integrated in an apparatus 8 for manufacturing flexographic digital printing plates 1.

This apparatus 8 can be of the type that extends horizontally, i.e., have work stations arranged in series, side by side, or of the type that extends vertically, such as those shown in Figs. 3 and 4, wherein the work stations are arranged one on top of the other.

In particular, the apparatus 8 of these figures comprises:
- a polymerization unit 9 of the plate 1, wherein the plate 1 is photopolymerized;
- a washing unit 10 of the polymerized plate 1, wherein the plate is washed and optionally subsequently treated with brushes;
- a finishing device 4 as described above, for finishing of the plate 1; and
- handling means suitable for picking up the plate 1 from the washing unit 10 and for transferring it into the finishing device 4.

As can be easily deduced, in Fig. 3 only the top portion of the apparatus 8, the portion relating to the finishing device 4, has been sectioned, for reasons of clarity.

Also in the case of apparatus 8 extending horizontally, it is advantageous to provide handling means suitable for picking up the plate 1 from the washing unit 10 and for transferring it into the finishing device 4.

A method of finishing flexographic digital printing plates 1 aimed at obtaining a clean and flexible surface of the plate 1 shall now be described.

The method comprises a first step a. of providing a plurality of UV-A LEDs 2 and a plurality of UV-C LEDs 3, wherein the LEDs are placed so that their radiating surface faces the surface of the plate 1 to be treated.

The step b. of the method of the invention comprises providing means for the relative movement between the plate 1 being processed, said plurality of UV-A LEDs 2 and said plurality of UV-C LEDs 3.

A step c. of radiating the surface of the plate 1 to be treated by means of said plurality of UV-A LEDs 2 and said plurality of UV-C LEDs 3 is then carried out.

Step d. of moving the plate 1 being processed or the plurality of UV-A LEDs 2 and the plurality of UV-C LEDs 3 along a feed direction x, with a such a speed v that the entire surface to be treated is radiated by the LEDs for a prefixed time is carried out substantially simultaneously to step c.

The feed speed v can be set manually by a user, before finishing starts, based on the features of the plate 1 and hence of the optimal photoexposure time, thanks to the constant and reliable conduct of the LEDs.

Alternatively, the finishing method comprises the further step e. of providing a CPU designed to adjust the moving speed of the plate 1 or the moving speed of the UV-A LEDs 2 and UV-C LEDs 3 and/or the exposure intensity, according to the type of plate 1 to be treated.

In this way, as already mentioned, it is possible to load different plates 1 into the finishing device 4, without requiring manual intervention and without the risk of errors.

The finishing method may also comprise cooling the plate 1, during or after the radiating step, in accordance with a step f. of the present invention. As mentioned previously, the purpose of this step is to prevent undesirable overheating of the plate 1.

As can be understood from the description, the method and the finishing device 4 according to the present invention allow the aims and objects set out to be fully achieved.

The method and the finishing device 4 thus conceived are susceptible to numerous possible variants, all falling within the scope of the present invention, which is defined by the appended claims only.

The materials employed and the dimensions and contingent shapes may be any, according to requirements and to the state of the art.

## Claims

1. Method of finishing flexographic digital printing plates (1) comprising the following steps:
a. providing a plurality of UV-A LEDs (2) and a plurality of UV-C LEDs (3), the LEDs being placed so that their radiating surfaces face the surface of the plate (1) to be treated;
b. providing means for relative movement between the plate (1) being processed, said plurality of UV-A LEDs (2) and said plurality of UV-C LEDs (3);
c. radiating the surface of the plate (1) to be treated by means of said plurality of UV-A LEDs (2) and said plurality of UV-C LEDs (3);
d. moving the plate (1) being processed or the plurality of UV-A LEDs (2) and the plurality of UV-C LEDs (3) along a feed direction (x), with such a speed (v) that the entire surface to be treated is radiated by the LEDs for a prefixed time.

2. Method of finishing flexographic digital printing plates (1) according to claim 1, further comprising the following step:
e. providing a CPU designed to adjust the moving speed of the plate (1) or the moving speed of the UV-A LEDs (2) and UV-C LEDs (3) and/or the exposure intensity, according to the type of plate (1) to be treated.

3. Finishing method according to claim 1 or 2, further comprising the following step:
f. cooling the plate (1) during or after the radiating step.

4. Finishing device (4) for finishing flexographic digital printing plates (1) comprising:
- an exposure chamber (5) hermetic to UV rays, wherein radiating of the plate (1) to be treated is carried out;
- a plurality of UV-A LEDs (2) and a plurality of UV-C LEDs (3) placed inside the exposure chamber (5) in such a way that the radiating surface of the LEDs faces the surface of the plate (1) to be treated, said pluralities of LEDs being suitable for radiating the plate (1) to be treated,
**characterised by**
- means for relative movement in said exposure chamber (5), along a feed direction (x), between the plate (1) being processed, said plurality of UV-A LEDs (2) and said plurality of UV-C LEDs (3).

5. Finishing device (4) according to claim 4, wherein at least one between said plurality of UV-A LEDs (2) and said plurality of UV-C LEDs (3) is located along at least one line substantially orthogonal to the feed direction (x) so as to form at least one row of LEDs.

6. Finishing device (4) according to claim 4 or 5, further comprising a CPU designed to adjust the moving speed of the plate (1) or the moving speed of the UV-A LEDs (2) and UV-C LEDs (3) and/or the exposure intensity, according to the type of plate (1) to be treated.

7. Finishing device (4) according to one of claims 4 - 6, further comprising means for adjusting the brightness of the LEDs and/or means for adjusting the distance between plate (1) to be treated and LEDs.

8. Finishing device (4) according to one of claims 4 - 7, further comprising means for cooling the plate (1).

9. Apparatus (8) for manufacturing flexographic digital printing plates (1) comprising a finishing device (4) according to one of claims 4 - 8.

10. Apparatus (8) according to claim 9, comprising a polymerization unit (9) for polymerizing the plate (1), a washing unit (10) for washing the polymerized plate (1), a finishing device (4) and handling means suitable for picking up the plate (1) from the washing unit (10) and for transferring it into the finishing device (4).

## Patentansprüche

1. Verfahren zum Veredeln flexographischer digitaler Druckplatten (1), aufweisend die folgenden Schritte:
a) Bereitstellen einer Mehrzahl an UV-A-LEDs (2) und einer Mehrzahl an UV-C-LEDs (3), wobei die LEDs so platziert werden, dass ihre Bestrahlungsflächen der Oberfläche der zu behandelnden Platte (1) gegenüberliegen;
b) Bereitstellen von Einrichtungen für eine relative Bewegung zwischen der zu behandelnden Platte (1), der Mehrzahl an UV-A-LEDs (2) und der Mehrzahl an UV-C-LEDs (3);
c) Bestrahlen der Oberfläche der zu behandelnden Platte (1) durch die Mehrzahl an UV-A-LEDs (2) und die Mehrzahl an UV-C-LEDs (3);
d) Bewegen der sich in Verarbeitung befindlichen Platte (1) oder der Mehrzahl an UV-A-LEDs (2) und der Mehrzahl an UV-C-LEDs (3) entlang einer Zuführrichtung (x) in einer solchen Geschwindigkeit (v), dass die gesamte zu behandelnde Oberfläche während einer vorher festgelegten Zeitspanne durch die LEDs bestrahlt wird.

2. Verfahren zum Veredeln flexographischer digitaler Druckplatten (1) nach Anspruch 1, ferner aufweisend den folgenden Schritt:
e) Bereitstellen einer CPU, die dafür ausgelegt ist, die Bewegungsgeschwindigkeit der Platte (1) oder die Bewegungsgeschwindigkeit der UV-A-LEDs (2) und der UV-C-LEDs (3) und/oder die Belichtungsintensität gemäß der Art der zu behandelnden Platte (1) einzustellen.

3. Veredelungsverfahren nach Anspruch 1 oder 2, ferner aufweisend den folgenden Schritt:
f) Kühlen der Platte (1) während oder nach dem Bestrahlungsschritt.

4. Veredelungsvorrichtung (4) zum Veredeln flexographischer digitaler Druckplatten (1), aufweisend:
- eine Belichtungskammer (5), die für UV-Strahlen hermetisch ist, wobei ein Bestrahlen der zu behandelnden Platte (1) ausgeführt wird;
- eine Mehrzahl an UV-A-LEDs (2) und eine Mehrzahl an UV-C-LEDs (3), die im Inneren der Belichtungskammer (5) in solch einer Weise platziert sind, dass die Bestrahlungsfläche der LEDs der Oberfläche der zu behandelnden Platte (1) gegenüberliegt, wobei die Mehrzahlen an LEDs dafür geeignet sind, die zu behandelnde Platte (1) zu bestrahlen,
**gekennzeichnet durch**
- Einrichtungen für eine relative Bewegung in der Belichtungskammer (5) entlang einer Zuführrichtung (x) zwischen der sich in Verarbeitung befindlichen Platte (1), der Mehrzahl an UV-A-LEDs (2) und der Mehrzahl an UV-C-LEDs (3).

5. Veredelungsvorrichtung (4) nach Anspruch 4, wobei zumindest eine von der Mehrzahl an UV-A-LEDs (2) und der Mehrzahl an UV-C-LEDs (3) sich entlang zumindest einer Geraden befindet, die im Wesentlichen rechtwinklig zu der Zuführrichtung (x) ist, so dass zumindest eine Reihe an LEDs gebildet wird.

6. Veredelungsvorrichtung (4) nach Anspruch 4 oder 5, ferner aufweisend eine CPU, die dafür ausgelegt ist, die Bewegungsgeschwindigkeit der Platte (1) oder die Bewegungsgeschwindigkeit der UV-A-LEDs (2) und der UV-C-LEDs (3) und/oder die Belichtungsintensität gemäß der Art der zu behandelnden Platte (1) einzustellen.

7. Veredelungsvorrichtung (4) nach einem der Ansprüche 4 bis 6, ferner aufweisend Einrichtungen zum Einstellen der Helligkeit der LEDs und/oder Einrichtungen zum Einstellen der Entfernung zwischen der zu behandelnden Platte (1) und den LEDs.

8. Veredelungsvorrichtung (4) nach einem der Ansprüche 4 bis 7, ferner aufweisend Einrichtungen zum Kühlen der Platte (1).

9. Vorrichtung (8) zum Herstellen flexographischer digitaler Druckplatten (1), aufweisend eine Veredelungsvorrichtung (4) nach einem der Ansprüche 4 bis 8.

10. Vorrichtung (8) nach Anspruch 9, aufweisend eine Polymerisierungseinheit (9) zum Polymerisieren der Platte (1), eine Wascheinheit (10) zum Waschen der polymerisierten Platte (1), eine Veredelungsvorrichtung (4) und Handhabungseinrichtungen, die geeignet sind, die Platte (1) von der Wascheinheit (10) aufzunehmen und sie in die Veredelungsvorrichtung (4) zu befördern.

## Revendications

1. Procédé de finition de plaques d'impression numérique flexographique (1) comprenant les étapes consistant à :
a) fournir une pluralité de DEL UV-A (2) et une pluralité de DEL UV-C (3), les DEL étant placées de sorte que leurs surfaces d'irradiation soient orientées vers la surface de la plaque (1) à traiter ;
b) fournir des moyens de déplacement relatif entre la plaque (1) en cours de traitement, ladite pluralité de DEL UV-A (2) et ladite pluralité de DEL UV-C (3) ;
c) irradier la surface de la plaque (1) à traiter au moyen de ladite pluralité de DEL UV-A (2) et de ladite pluralité de DEL UV-C (3) ;
d) déplacer la plaque (1) en cours de traitement ou la pluralité de DEL UV-A (2) et la pluralité de DEL UV-C (3) le long d'une direction d'avance (x), avec une vitesse (v) telle que toute la surface à traiter soit irradiée par les DEL pendant un temps prédéfini.

2. Procédé de finition de plaques d'impression numérique flexographique (1) selon la revendication 1, comprenant l'étape suivante consistant à :
e) fournir une unité centrale de traitement, CPU, conçue pour ajuster la vitesse de déplacement de la plaque (1) ou la vitesse de déplacement des DEL UV-A (2) et des DEL UV-C (3) et/ou l'intensité d'exposition, en fonction du type de plaque (1) à traiter.

3. Procédé de finition selon la revendication 1 ou 2, comprenant en outre l'étape suivante consistant à :
f) refroidir la plaque (1) pendant ou après l'étape d'irradiation.

4. Dispositif de finition (4) pour une finition de plaques d'impression numérique flexographique (1), comprenant :
- une chambre d'exposition (5) hermétique aux rayons UV, dans laquelle est réalisée une irradiation de la plaque (1) à traiter ;
- une pluralité de DEL UV-A (2) et une pluralité de DEL UV-C (3) placées à l'intérieur de la chambre d'exposition (5) de telle manière que la surface d'irradiation des DEL soit orientée vers la surface de la plaque (1) à traiter, lesdites pluralités de DEL étant adaptées pour irradier la plaque (1) à traiter,
**caractérisé par**
- des moyens de déplacement relatif dans ladite chambre d'exposition (5), selon une direction d'avance (x), entre la plaque (1) en cours de traitement, ladite pluralité de DEL UV-A (2) et ladite pluralité de DEL UV-C (3).

5. Dispositif de finition (4) selon la revendication 4, dans lequel au moins une parmi ladite pluralité de DEL UV-A (2) et ladite pluralité de DEL UV-C (3) est située le long d'au moins une ligne sensiblement orthogonale à la direction d'avance (x) de manière à former au moins une rangée de DEL.

6. Dispositif de finition (4) selon la revendication 4 ou 5, comprenant en outre une unité centrale de traitement, CPU, conçue pour ajuster la vitesse de déplacement de la plaque (1) ou la vitesse de déplacement des DEL UV-A (2) et des DEL UV-C (3) et/ou l'intensité d'exposition, en fonction du type de plaque (1) à traiter.

7. Dispositif de finition (4) selon l'une des revendications 4-6, comprenant en outre des moyens pour ajuster la luminosité des DEL et/ou des moyens pour ajuster la distance entre la plaque (1) à traiter et les DEL.

8. Dispositif de finition (4) selon l'une des revendications 4-7, comprenant en outre des moyens pour refroidir la plaque (1).

9. Appareil (8) de fabrication de plaques d'impression numérique flexographique (1) comprenant un dispositif de finition (4) selon l'une des revendications 4-8.

10. Appareil (8) selon la revendication 9, comprenant une unité de polymérisation (9) pour polymériser la plaque (1), une unité de lavage (10) pour laver la plaque polymérisée (1), un dispositif de finition (4) et des moyens de manutention adaptés pour prélever la plaque (1) à partir de l'unité de lavage (10) et pour la transférer jusque dans le dispositif de finition (4).
